# EUROPEAN PATENT APPLICATION

(11) **EP 2 164 109 A1**
(43) Date of publication of application: **17.03.2010**
(21) Application number: 09011603.9
(22) Date of filing: 10.09.2009
(51) Int. Cl.: H01L 31/042, H01L 31/02

(54) **Photovoltaic cell circuit**

(30) Priority: 15.09.2008 SG 200806818
(71) Applicant: Alternative Energy Technology Pte. Ltd., Singapore 069545 (SG)
(72) Inventor: Nightingale, Christopher George Edward, Singapore 259983 (SG); Lee, Wai Hong, Singapore 391011 (SG); Tay, Boon Hou, Singapore 438814 (SG); Goh, Swee Ming, Singapore 591401 (SG); Ang, Teck Wee, Singapore 390049 (SG)
(74) Representative: Moore, Derek

(57) **Abstract**

A photovoltaic cell circuit (40, 50) is disclosed which comprises a plurality of photovoltaic cells (12) connected in series. At least one switching device (42) is shunted across a group of one or more of the photovoltaic cells (12). The switching device (42) provides a current path for the circuit (40, 50) when light is obstructed from impinging on one or more of the photovoltaic cells (12) across which the switching device (42) is shunted.

## Description

### Field of the Invention

The present invention broadly relates to a photovoltaic cell circuit, particularly, though not exclusively, for use on the roof of a building for converting solar energy to electrical energy.

### Background of the Invention

A plurality of photovoltaic cells may be connected in series to generate a voltage required for a specific application.

There is the possibility that foreign matter such as leaves and bird excreta may shade one or more of these photovoltaic cells from impinging light. In a situation such as this, and due to the series connection of the photovoltaic cells, the achievable power output of the plurality of photovoltaic cells may be significantly reduced.

### Summary of the Invention

In accordance with an aspect of the present invention there is provided a photovoltaic cell circuit comprising:
a plurality of photovoltaic cells connected in series; and
at least one switching device shunted across a group of one or more of the photovoltaic cells, where the switching device provides a current path for the circuit when light is obstructed from impinging on one or more of the photovoltaic cells across which the switching device is shunted.

The switching device may further comprise one of a plurality of switching devices, each switching device being shunted across respective groups of one or more photovoltaic cells. At least one of the switching devices may be a diode. At least one diode may have a forward voltage drop of equal to or less than 0.7 V.

The photovoltaic cell circuit may be arranged so at least one diode is shunted across one or more of the photovoltaic cells in a manner such that the diode is reverse biased by the one or more photovoltaic cells across which it is shunted.

The groups of one or more photovoltaic cells may be arranged on a roof for the collection and conversion of solar energy into electrical energy.

The at least one diode may be thermally insulated so as to reduce leakage current of the at least one diode.

The at least one diode may be insulated from heat due to exposure to light by a layer of insulating material arranged between the diode and impinging light.

In accordance with a further aspect of the present invention there is provided a method of connecting a photovoltaic cell circuit, the method comprising:
connecting a plurality of photovoltaic cells in series; and
shunting at least one switching device across a group of one or more of the photovoltaic cells.

### Brief Description of the Drawings

The invention will now be described, by way of example only, with reference to the accompanying drawings, in which:
Figure 1 shows a perspective view of a photovoltaic cell circuit;
Figure 2 shows a graph of the open circuit voltage of the photovoltaic cell circuit as a function of the number of photovoltaic cells that are shaded from impinging light;
Figure 3 shows a circuit diagram of the photovoltaic cell circuit of Figure 1;
Figure 4 shows a circuit diagram of a photovoltaic cell circuit in accordance with an embodiment of the present invention;
Figure 5 shows a circuit diagram of the photovoltaic cell circuit of Figure 4 having a photovoltaic cell shaded from impinging light;
Figure 6 is a circuit diagram of a photovoltaic cell circuit in accordance with a further embodiment of the present invention; and
Figure 7 is a circuit diagram showing a series connection of two photovoltaic cell circuits of the type shown in Figure 6.

### Detailed Description of Specific Embodiments

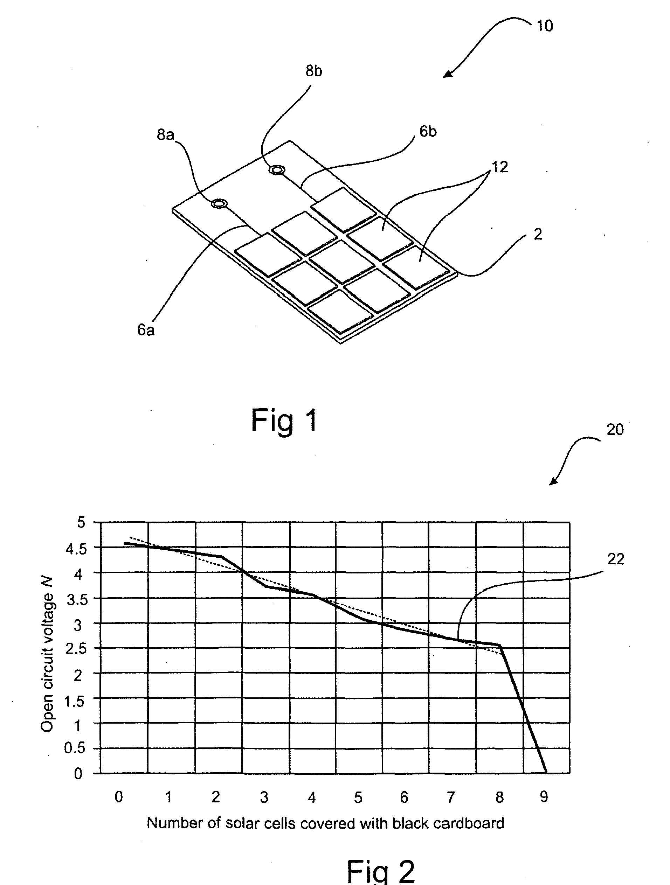

Figure 1 depicts a photovoltaic tile 2 comprising a plurality of photovoltaic cells 12a-12i (hereinafter referred to in general as 'photovoltaic cells 12' or 'cells 12') connected together in series. A first and last of the series connected photovoltaic cells 12 are electrically coupled by respective bus bars 6a and 6b to electrical terminals 8a and 8b. The series connected cells 12 form a photovoltaic cell circuit 10.

Figure 2 shows a graph 20 displaying an open circuit voltage 22 of the photovoltaic cell circuit 10 as a function of the number of photovoltaic cells 12 shaded from an impinging light source. It can be seen that the open circuit voltage 22 reduces in a substantially linear fashion as the photovoltaic cells are progressively shaded.

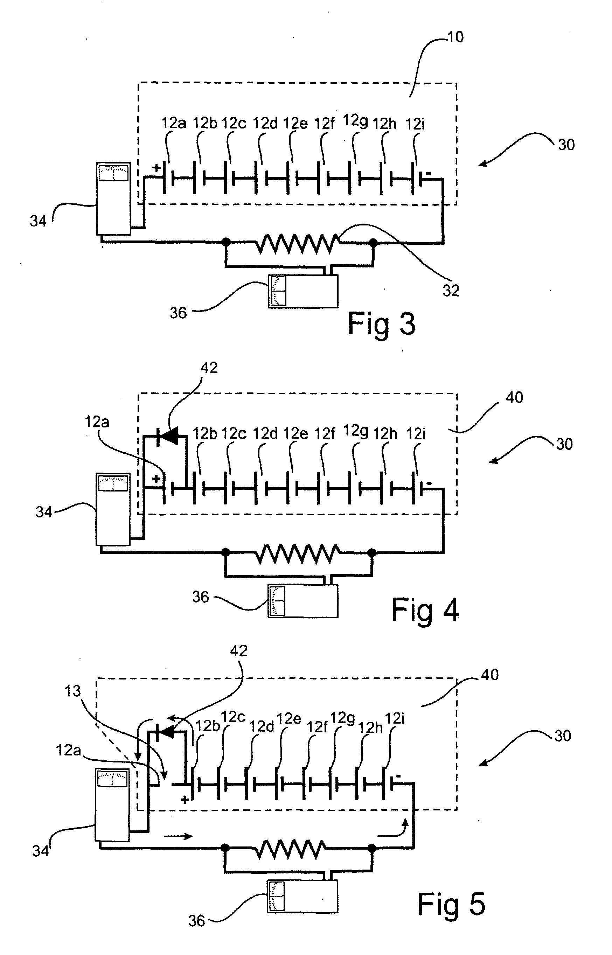

Figure 3 shows a test circuit 30 for the series connection of photovoltaic cells 12 forming the photovoltaic cell circuit 10 shown in Figure 1. The test circuit 30 comprises a series connected load 32 and a first multimeter 34 to measure the current flowing through the load 32 and hence the test circuit 30. A second multimeter 36 is connected in parallel with the load 32 so as to measure the voltage across the load 32.

The test circuit 30 was used in an experiment conducted to test the effects of shading photovoltaic cells 12 from impinging light. The current flowing through and the voltage drop across the load 32 were measured by the first and second multimeters 34, 36 respectively. From these measurements, the power drawn by the load 32 was calculated. In this example and the examples that follow, the load resistance was 33.3Ω.

In a first test, no photovoltaic cells 12 were shaded from impinging light. The current, voltage and power of the load 32 were found to be:

| Diode connected across photovoltaic cell(s): | Shaded photovoltaic cell(s): | Voltage across load 32 (V) | Current through load 32 (mA) | Power drawn by load 32 (mW) |
|---|---|---|---|---|
| (no diode connected) | None | 2.8 | 85.5 | 239.4 |

In a second test, the photovoltaic cell 12a was shaded from impinging light. Under these conditions the current, voltage and power of the load 32 were found to be:

| Diode connected across photovoltaic cell(s): | Shaded photovoltaic cell(s): | Voltage across load 32 (V) | Current through load 32 (mA) | Power drawn by load 32 (mW) |
|---|---|---|---|---|
| (no diode connected) | 12a | 0.246 | 7.4 | 1.8204 |

In the second test it can be seen that shading one photovoltaic cell 12 caused the total power output to drop to 0.76% of the power output when no photovoltaic cells 12 were shaded.

Figure 4 shows a photovoltaic cell circuit 40 in accordance with an embodiment of the present invention connected in the same test circuit 30. The photovoltaic cell circuit 40 comprises a plurality of photovoltaic cells 12 connected in series and a switching device in the form of a diode 42 connected in parallel with photovoltaic cell 12a. In this example the diode 42 is reverse biased with respect to photovoltaic cell 12a. If photovoltaic cell 12a is shaded from impinging light, the photovoltaic cell 12a acts as a substantial open circuit but the diode 42 provides an alternate pathway for the current to flow through the circuit as shown in Figure 5. This leads to less power loss than the situation described with reference to Figure 3 where photovoltaic cell 12a was shaded from impinging light and a diode or other switching device was not present.

The effectiveness of embodiments of the invention is illustrated using the test circuit 30 and explained below. Initially, no photovoltaic cells 12 in the photovoltaic cell circuit 40 were shaded from impinging light. Current and voltage measurements were taken of the load 32 by the first and second multimeters 34, 36 respectively. The current, voltage and power of the load 32 were found to be:

| Diode connected across photovoltaic cell(s): | Shaded photovoltaic cell(s): | Voltage across load 32 (V) | Current through load 32 (mA) | Power drawn by load 32 (mW) |
|---|---|---|---|---|
| 12a | None | 2.49 | 81.3 | 202.437 |

Figure 5 shows the photovoltaic cell circuit 40 of Figure 4 where the photovoltaic cell 12a has been shaded from impinging light. This has effectively caused the photovoltaic cell 12a to become an open circuit 13. In this situation, the diode 42 is forward biased with respect to the remaining eight photovoltaic cells 12 and so current is able to flow through the diode 42. The current, voltage and power of the load 32 were found to be:

| Diode connected across photovoltaic cell (s) : | Shaded photovoltaic cell(s): | Voltage across load 32 (V) | Current through load 32 (mA) | Power drawn by load 32 (mW) |
|---|---|---|---|---|
| 12a | 12a | 1.82 | 54.5 | 99.19 |

This represents a power output of 41.4% compared to the configuration where no photovoltaic cells 12 were shaded from impinging light and no diode was present.

Further experiments were conducted where various photovoltaic cells 12 were shaded from impinging light and where the diode 42 was connected in parallel with various photovoltaic cells 12. A table of results displaying the outcomes of some of these experiments is shown below:

| Diode connected across photovoltaic cell(s): | Shaded photovoltaic cell(s): | Voltage across load 32 (V) | Current through load 32 (mA) | Power drawn by load 32 (mW) |
|---|---|---|---|---|
| (no diode connected) | None | 2.8 | 85.5 | 239.4 |
| (no diode connected) | 12a | 0.246 | 7.4 | 1.8204 |
| 12a | None | 2.49 | 81.73 | 202.437 |
| 12a | 12a | 1.82 | 54.5 | 99.19 |
| (no diode connected) | 12a, 12b | 0.066 | 2 | 0.132 |
| 12a, 12b | None | 2.46 | 75.5 | 183.27 |
| 12a, 12b | 12a | 1.5 | 45 | 67.5 |
| 12a, 12b | 12a, 12b | 1.6 | 48.7 | 77.92 |
| (no diode connected) | 12a, 12b, 12c | 0.031 | 0.9 | 0.0279 |
| 12a, 12b, 12c | None | 2.15 | 63.5 | 136.525 |
| 12a, 12b, 12c | 12a | 1.1 | 33.4 | 36.74 |
| 12a, 12b, 12c | 12a, 12b | 1.26 | 38.7 | 48.762 |
| 12a, 12b, 12c | 12a, 12b, 12c | 1.23 | 37 | 45.51 |
| 12a, 12b, 12c, 12d | None | 2.2 | 67 | 147.4 |
| 12a, 12b, 12c, 12d | 12a | 0.73 | 22 | 16.06 |
| 12a, 12b, 12c, 12d, 12e | 12a | 0.57 | 16.3 | 9.291 |
| 12a, 12b, 12c, 12d, 12e, 12f | 12a | 0.49 | 15.3 | 7.497 |
| 12a, 12b, 12c, 12d, 12e, 12f, 12g | 12a | 0.24 | 6.8 | 1.632 |
| 12a, 12b, 12c, 12d, 12e, 12f, 12g, 12h | 12a | 0.29 | 8.7 | 2.523 |
| 12a, 12b, 12c, 12d | None | 2.24 | 67.8 | 151.872 |
| 12a, 12b, 12c, 12d, 12e | None | 2.07 | 61.5 | 127.305 |
| 12a, 12b, 12c, 12d, 12e, 12f | None | 1.94 | 59.6 | 115.624 |
| 12a, 12b, 12c, 12d, 12e, 12f, 12g | None | 2.29 | 68.8 | 157.552 |
| 12a, 12b, 12c, 12d, 12e, 12f, 12g, 12h | None | 2.19 | 66.4 | 1453416 |
| 12a, 12b, 12c, 12d, 12e, 12f, 12g, 12h, 12i | None | 2.5 | 75 | 187.5 |

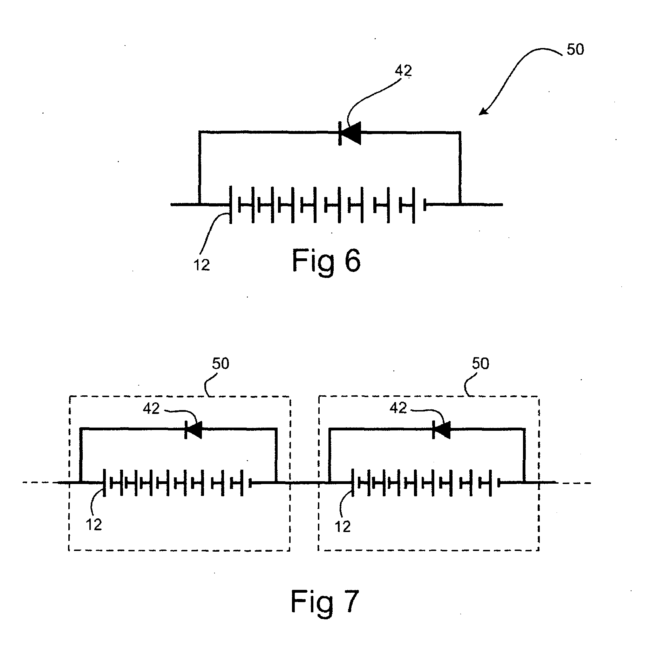

Figure 6 shows an example of a photovoltaic cell circuit 50 comprising a plurality of series connected cells 12 and having a diode 42 connected in parallel across the plurality of cells 12. With reference to Figure 2, this circuit is realised by placing the diode 42 across the terminals 8a and 8b of the photovoltaic tile 2. The diode 42 is reverse biased with respect to the plurality of cells 12. In the event that one or more of the cells 12 is shaded from impinging light, the diode 42 can provide an alternate pathway through which current can flow. This can be particularly advantageous when a plurality of photovoltaic cell circuits 50, and specifically a plurality of photovoltaic tiles 2, are connected in series as described below.

The photovoltaic cell circuit 50 may be connected in series with further photovoltaic cell circuits 50 as shown in Figure 7. This is equivalent to the series connecting of photovoltaic tiles 2 where each photovoltaic tile 2 has a diode 42 across their respective terminals 8a, 8b. If a cell 12 from any one of the photovoltaic cell circuits 50 is shaded from impinging light, the respective diode 42 of the respective photovoltaic cell circuit 50 can provide an alternate pathway through which current can flow. In this way, the shading of one or more cells 12 from impinging light does not result in as large a power loss than if a diode or other switching device was not connected across each photovoltaic cell circuit 50.

In an alternative embodiment, the diode 42 may be applied across a plurality of photovoltaic cells 12, for example an array of photovoltaic tiles 2 in a roof mounted solar energy system. This can provide the advantage whereby a higher voltage can be attained to overcome the voltage drop when a constituent photovoltaic cell 12 is shaded from impinging sunlight.

The parallel connection of the diode 42 in each photovoltaic cell circuit 50 localises the adverse effects of one or more of the cells 12 of each photovoltaic cell circuit 50 being shaded from impinging light. The voltage drop across the diode 42 will be negligible if the series connection of photovoltaic cell circuits 50 is generating a sufficiently high voltage, for example in the range of 100V and above. This allows a plurality of series connected photovoltaic cell circuits 50 (i.e. photovoltaic tiles 2) to be used to generate a voltage high enough to, for example, run an inverter while providing a means whereby the shading of light from impinging on one or more cells 12 will not reduce the achievable voltage by as much than if there were no diode or other switching device used.

In a specific example, the diode 42 can be used in conjunction with a roof mounted solar system. In particular, when a roof is arranged to have mounted on it a plurality of photovoltaic tiles 2 that are connected in series, the diode 42 or a plurality of diodes 42 can be connected in parallel with any combination of photovoltaic cells 12 so as to reduce the adverse effect of one or more photovoltaic cells 12 being shaded from impinging light.

In one embodiment the diodes 42 are thermally insulated, for example from heating by impinging sunlight. In this way, the leakage current of the diode 42 which is dependent on the temperature of the diode 42 can be reduced to some extent. When the photovoltaic tiles 2 are mounted on a roof or form part of a roof solar energy system, the diodes 42 can be insulated from heating due to impinging sunlight by a layer or layers arranged between the diode 42 and the impinging sunlight. The layers may be any one of or a plurality of insulating materials, for example air gaps between components of a photovoltaic tile 2 or any other insulating means. It is envisaged that any form of effective thermal insulation can be used to reduce the leakage current of the diodes 42. Other devices may be used to cool the diodes 42 such as cooling systems, devices arranged to emit thermal radiation away from the diode 42 such as finned metallic radiators, and fans.

Although the invention has been described with reference to particular examples, it will be appreciated by those skilled in the art that the invention may be embodied in many other forms. For example, other types of switching devices may be shunted across a photovoltaic cell to provide an alternate pathway for current to flow in the event that the photovoltaic cell is shaded from impinging light. Such devices may include antifuses or transistor switching devices.

Also, while the photovoltaic cell circuit 40 is described as a series connected circuit with a single shunted switching device, the invention may also be applied to photovoltaic cell circuits connected in parallel, or a combination of both series and parallel circuits where a switching device is placed across any number of photovoltaic cells. Alternatively, a switching device may be placed across each photovoltaic cell or in combination with switching devices placed across a plurality of cells.

Further, while the illustrated embodiments incorporate a diode type switching device with a forward voltage drop of equal or less than 0.7V, alternate switching device such as an anti-fuse or a transistor switching device with no, or a similar low forward, voltage drop may be used.

## Claims

1. A photovoltaic cell circuit comprising:
a plurality of photovoltaic cells connected in series; and
at least one switching device shunted across a group of one or more of the photovoltaic cells, where the switching device provides a current path for the circuit when light is obstructed from impinging on one or more of the photovoltaic cells across which the switching device is shunted.

2. A photovoltaic cell circuit according to claim 1, wherein the switching device is one of a plurality of switching devices, each switching device being shunted across respective groups of one or more photovoltaic cells.

3. A photovoltaic cell circuit according to claim 1 or claim 2, wherein at least one of the switching devices is a diode.

4. A photovoltaic cell circuit according to claim 3, wherein at least one diode has a forward voltage drop of equal to or less than 0.7 V.

5. A photovoltaic cell circuit according to claim 3, wherein at least one switching device is an anti-fuse or a transistor switching device.

6. A photovoltaic cell according to any one of claims 3 to claim 5, wherein at least one diode is shunted across one or more of the photovoltaic cells in a manner such that the diode is reverse biased by the one or more photovoltaic cells across which it is shunted.

7. A photovoltaic cell circuit according to any one of the preceding claims wherein the groups of one or more photovoltaic cells are arranged on a roof for the collection and conversion of solar energy into electrical energy.

8. A photovoltaic cell circuit according to any one of the preceding claims, wherein at least one diode is thermally insulated so as to reduce leakage current of the at least one diode.

9. A photovoltaic cell circuit according to claim 8, wherein the at least one diode is insulated from heat due to exposure to light by a layer of insulating material arranged between the diode and impinging light.

10. A method of connecting a photovoltaic cell circuit, the method comprising:
connecting a plurality of photovoltaic cells in series; and
shunting at least one switching device across a group of one or more of the photovoltaic cells.
